# EUROPÄISCHE PATENTANMELDUNG

(11) **EP 4 819 763 A1**
(43) Veröffentlichungstag der Anmeldung: **07.10.2026**
(21) Anmeldenummer: 26167092.1
(22) Anmeldetag: 24.03.2026
(51) Int. Cl.: H05B 6/06

(54) **VERFAHREN ZUM BETREIBEN EINER INDUKTIONSHEIZEINRICHTUNG UND INDUKTIONSHEIZEINRICHTUNG**

(30) Priorität: 02.04.2025 DE 102025112957
(71) Anmelder: E.G.O. Elektro-Gerätebau GmbH, 75038 Oberderdingen (DE)
(72) Erfinder: Wang, Wenlong, Suzhou 215400 (CN); Wächter, Ulrich, 76646 Bruchsal (DE); Frank, Marcus, 75056 Sulzfeld (DE); Herweg, Elmar, 75038 Oberderdingen (DE)
(74) Vertreter: Patentanwälte Ruff, Wilhelm, Beier, Dauster & Partner mbB

(57) **Zusammenfassung**

Verfahren zum Betreiben einer Induktionsheizeinrichtung (100),

- wobei die Induktionsheizeinrichtung (100) aufweist:
- einen Gleichspannungszwischenkreis (1) mit einem positiven Zwischenkreiszweig (1a), der ein positives Zwischenkreispotential führt, und einem negativen Zwischenkreiszweig (1b), der ein negatives Zwischenkreispotential führt, wobei zwischen dem positiven Zwischenkreiszweig (1a) und dem negativen Zwischenkreiszweig (1b) eine Zwischenkreisgleichspannung (9) ansteht,
- einen Parallelschwingkreis aufweisend einen Kondensator (2) und eine dem Kondensator (2) parallel geschaltete Induktionsheizspule (3), wobei mittels der Induktionsheizspule (3) ein magnetisches Wechselfeld zum Beheizen eines Kochgeschirrs (200) erzeugbar ist, und
- ein Halbleiterschaltmittel (4), und
- wobei der Parallelschwingkreis (2, 3) und das Halbleiterschaltmittel (4) in Reihe zwischen den positiven Zwischenkreiszweig (1a) und den negativen Zwischenkreiszweig (1b) eingeschleift sind,

- wobei das Verfahren am Beginn eines Beheizens die Schritte aufweist:
- Ansteuern des Halbleiterschaltmittels (4) mittels eines ersten PWM-Signals mit einer ersten Frequenz während einer Ladezeitdauer zum Laden des Kondensators (2).

## Beschreibung

Der Erfindung liegt die Aufgabe zugrunde, ein Verfahren zum Betreiben einer Induktionsheizeinrichtung und eine Induktionsheizeinrichtung zur Verfügung zu stellen, die einen möglichst bauteilschonenden Betrieb der Induktionsheizeinrichtung ermöglichen.

Das erfindungsgemäße Verfahren dient zum Betreiben einer Induktionsheizeinrichtung.

Die Induktionsheizeinrichtung weist einen Gleichspannungszwischenkreis mit einem positiven Zwischenkreiszweig, der ein positives Zwischenkreispotential führt, und einem negativen Zwischenkreiszweig auf, der ein negatives Zwischenkreispotential führt. Zwischen dem positiven Zwischenkreiszweig und dem negativen Zwischenkreiszweig steht während des Betriebs der Induktionsheizeinrichtung eine Zwischenkreisgleichspannung an.

Die Induktionsheizeinrichtung weist weiter einen Parallelschwingkreis aufweisend einen Kondensator und eine dem Kondensator parallel geschaltete Induktionsheizspule auf, wobei mittels der Induktionsheizspule ein magnetisches Wechselfeld zum Beheizen eines Kochgeschirrs erzeugbar ist.

Die Induktionsheizeinrichtung weist weiter ein, insbesondere genau ein, Halbleiterschaltmittel auf, beispielsweise in Form eines IGBT.

Der Parallelschwingkreis und das Halbleiterschaltmittel sind in Reihe zwischen den positiven Zwischenkreiszweig und den negativen Zwischenkreiszweig eingeschleift.

Die Induktionsheizeinrichtung weist weiter eine Steuereinheit auf, beispielsweise in Form einer Mikroprozessorsteuerung, die das Halbleiterschaltmittel derart ansteuert, dass ein nachfolgend beschriebenes Verfahren ausgeführt wird.

Das Verfahren weist am Beginn bzw. Start eines Beheizens den Schritt auf: Ansteuern des Halbleiterschaltmittels mittels eines ersten PWM-Signals mit einer ersten Frequenz während einer Ladezeitdauer zum (Vor-) Laden des Kondensators.

In einer Ausführungsform liegt die erste Frequenz in einem Frequenzbereich zwischen 200 kHz und 3 MHz.

In einer Ausführungsform weist das erste PWM-Signal ein Tastverhältnis von kleiner als 20 % auf.

In einer Ausführungsform liegt die Ladezeitdauer in einem Bereich zwischen 0,5 µs und 5 µs. Die Ladezeitdauer kann alternativ auch variabel derart gewählt werden, dass eine Spannung über dem Halbleiterschaltmittel kleiner ist als eine Maximalspannung, beispielsweise kleiner als beispielsweise 150 V, insbesondere kleiner als 100 V wird.

In einer Ausführungsform weist das Verfahren nach dem Beginn eines Beheizens bzw. nach den oben beschriebenen Schritten den sich anschließenden weiteren Schritt auf: Ansteuern des Halbleiterschaltmittels mittels eines zweiten PWM-Signals mit einer zweiten Frequenz.

In einer Ausführungsform liegt die zweite Frequenz in einem Bereich zwischen 20 kHz und 65 kHz.

In einer Ausführungsform weist das zweite PWM-Signal ein Tastverhältnis in einem Bereich zwischen 15 % und 25 % auf.

In einer Ausführungsform weist die Induktionsheizeinrichtung eine Gleichspannungsversorgung zur, insbesondere stabilisierten, Erzeugung der Zwischenkreisgleichspannung auf. Die Gleichspannungsversorgung ist bevorzugt dazu ausgebildet, die Zwischenkreisgleichspannung derart stabilisiert zu erzeugen, dass die Zwischenkreisgleichspannung lastunabhängig innerhalb eines vorgegebenen Spannungsbereichs erzeugt wird, beispielsweise in einem Spannungsbereich zwischen 200 V und 240 V.

Die Erfindung wird nachfolgend unter Bezugnahme auf die Zeichnungen detailliert beschrieben. Hierbei zeigt:
- Fig. 1: ein schematisches Schaltbild einer Induktionsheizeinrichtung und
- Fig. 2: Signale über der Zeit der in Fig. 1 gezeigten Induktionsheizeinrichtung.

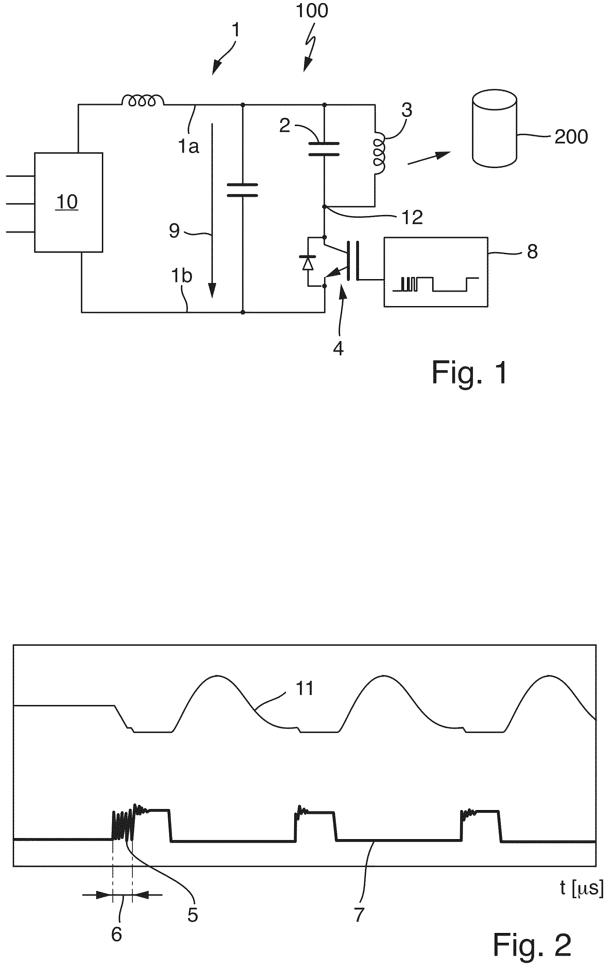

Fig. 1 zeigt ein schematisches Schaltbild einer Induktionsheizeinrichtung 100.

Die Induktionsheizeinrichtung 100 weist einen Gleichspannungszwischenkreis 1 mit einem positiven Zwischenkreiszweig 1a, der ein positives Zwischenkreispotential führt, und einem negativen Zwischenkreiszweig 1b auf, der ein negatives Zwischenkreispotential führt. Zwischen dem positiven Zwischenkreiszweig 1a und dem negativen Zwischenkreiszweig 1b steht eine Zwischenkreisgleichspannung 9 an.

Die Induktionsheizeinrichtung 100 weist weiter einen Parallelschwingkreis aufweisend einen Kondensator 2 und eine dem Kondensator 2 parallel geschaltete Induktionsheizspule 3 auf, wobei mittels der Induktionsheizspule 3 ein magnetisches Wechselfeld zum Beheizen eines Kochgeschirrs 200 erzeugbar ist.

Die Induktionsheizeinrichtung 100 weist weiter ein Halbleiterschaltmittel 4 in Form eines IGBT auf, wobei der Parallelschwingkreis 2, 3 und das Halbleiterschaltmittel 4 in Reihe zwischen den positiven Zwischenkreiszweig 1a und den negativen Zwischenkreiszweig 1b eingeschleift sind.

Die Induktionsheizeinrichtung 100 weist weiter eine Steuereinheit 8 auf, die das Halbleiterschaltmittel 4 derart ansteuert, dass ein nachfolgend beschriebenes Verfahren ausgeführt wird.

Die Induktionsheizeinrichtung 100 weist weiter eine Gleichspannungsversorgung 10 zur stabilisierten Erzeugung der Zwischenkreisgleichspannung 9 auf.

Fig. 2 zeigt eine Spannung 11 am Kollektor 12 des Halbleiterschaltmittels 4, ein erstes PWM-Signal 5 und ein sich an das erste PWM-Signal 5 anschließendes zweites PWM-Signal 7 über der Zeit, wobei die PWM-Signale 5 und 7 mittels der Steuereinheit 8 erzeugt werden und zum Ansteuern des Halbleiterschaltmittels 4 dienen.

Wie dargestellt, wird das Halbleiterschaltmittel 4 mittels des ersten PWM-Signals 5 mit einer ersten Frequenz während einer Ladezeitdauer 6 zum Laden des Kondensators 2 angesteuert. Die erste Frequenz liegt in einem Bereich zwischen 200 kHz und 3 MHz. Das erste PWM-Signal 5 weist ein Tastverhältnis von kleiner als 20 % auf. Die Ladezeitdauer 6 liegt in einem Bereich zwischen 0,5 µs und 5 µs.

Nach dem Beginn des Beheizens bzw. nach Ablauf der Ladezeitdauer 6 wird das Halbleiterschaltmittel 4 mittels des zweiten PWM-Signals 7 mit einer zweiten Frequenz angesteuert. Die zweite Frequenz liegt in einem Bereich zwischen 20 kHz und 65 kHz. Das zweite PWM-Signal 7 weist heizleistungsabhängig ein Tastverhältnis in einem Bereich zwischen 15 % und 60 % auf.

Die vorliegende Erfindung stellt ein Verfahren zum Ansteuern eines Gate-Anschlusses eines IGBT in Verbindung mit einem quasi-resonanten Schalten einer Induktionsheizeinrichtung zur Verfügung, die aus einer stabilisierten Gleichspannungsversorgung versorgt ist.

Die Zwischenkreisspannung weist einen hohen Pegel auf, während nicht geheizt wird, was bei herkömmlichen Lösungen zu einem hohen Kollektorstrom beim Einschalten des IGBT führt.

Bei der vorliegenden Speisung des Zwischenkreises aus einer stabilisierten Gleichspannungsversorgung kann der Zwischenkreis nicht entladen werden, da anders als bei der Versorgung des Zwischenkreises durch einen Netzgleichrichter kein Nulldurchgang des den Netzgleichrichter speisenden Wechselspannungsnetzes vorhanden ist.

Erfindungsgemäß wird bei einem Start des Beheizens der Schwingkreis-Kondensator mittels eines hochfrequentem Pulsmusters geladen, was das Halbleiterschaltmittel bzw. den IGBT gegen Beschädigung schützt.

Es werden beispielsweise mehrere Pulse zum Ansteuern des IGBT zum Verringern des Kollektorstroms beim Starten verwendet. Die Ansteuerfrequenz kann beispielsweise 1,55 MHz mit einem Tastverhältnis von 17 % betragen.

Nach beispielsweise 4 Pulsen kann die Frequenz zur normalen Arbeitsfrequenz von beispielsweise 40 kHz mit einem Tastverhältnis von 20 % verändert werden.

Erfindungsgemäß kann der maximal auftretenden Kollektorstrom deutlich reduziert werden, um den IGBT gegen Beschädigung zu schützen. Das erfindungsgemäße Verfahren erfordert keine Veränderung der herkömmlichen Ansteuertopologie.

## Patentansprüche

1. Verfahren zum Betreiben einer Induktionsheizeinrichtung (100),
- wobei die Induktionsheizeinrichtung (100) aufweist:
- einen Gleichspannungszwischenkreis (1) mit einem positiven Zwischenkreiszweig (1a), der ein positives Zwischenkreispotential führt, und einem negativen Zwischenkreiszweig (1b), der ein negatives Zwischenkreispotential führt, wobei zwischen dem positiven Zwischenkreiszweig (1a) und dem negativen Zwischenkreiszweig (1b) eine Zwischenkreisgleichspannung (9) ansteht,
- einen Parallelschwingkreis aufweisend einen Kondensator (2) und eine dem Kondensator (2) parallel geschaltete Induktionsheizspule (3), wobei mittels der Induktionsheizspule (3) ein magnetisches Wechselfeld zum Beheizen eines Kochgeschirrs (200) erzeugbar ist, und
- ein Halbleiterschaltmittel (4),
- wobei der Parallelschwingkreis (2, 3) und das Halbleiterschaltmittel (4) in Reihe zwischen den positiven Zwischenkreiszweig (1a) und den negativen Zwischenkreiszweig (1b) eingeschleift sind,
- wobei das Verfahren am Beginn eines Beheizens den Schritt aufweist:
- Ansteuern des Halbleiterschaltmittels (4) mittels eines ersten PWM-Signals (5) mit einer ersten Frequenz während einer Ladezeitdauer (6) zum Laden des Kondensators (2).

2. Verfahren nach Anspruch 1, **dadurch gekennzeichnet, dass**
- die erste Frequenz in einem Bereich zwischen 200 kHz und 3 MHz liegt.

3. Verfahren nach einem der vorhergehenden Ansprüche, **dadurch gekennzeichnet, dass**
- das erste PWM-Signal (5) ein Tastverhältnis von kleiner als 20 % aufweist.

4. Verfahren nach einem der vorhergehenden Ansprüche, **dadurch gekennzeichnet, dass**
- die Ladezeitdauer (6) in einem Bereich zwischen 0,5 µs und 5 µs liegt.

5. Verfahren nach einem der vorhergehenden Ansprüche, **dadurch gekennzeichnet, dass**
- das Verfahren nach dem Beginn eines Beheizens den Schritt aufweist:
- Ansteuern des Halbleiterschaltmittels (4) mittels eines zweiten PWM-Signals (7) mit einer zweiten Frequenz.

6. Verfahren nach Anspruch 5, **dadurch gekennzeichnet, dass**
- die zweite Frequenz in einem Bereich zwischen 20 kHz und 65 kHz liegt.

7. Verfahren nach einem der Ansprüche 5 oder 6, **dadurch gekennzeichnet, dass**
- das zweite PWM-Signal (7) ein Tastverhältnis in einem Bereich zwischen 15 % und 60 % aufweist.

8. Induktionsheizeinrichtung (100), aufweisend:
- einen Gleichspannungszwischenkreis (1) mit einem positiven Zwischenkreiszweig (1a), der ein positives Zwischenkreispotential führt, und einem negativen Zwischenkreiszweig (1b), der ein negatives Zwischenkreispotential führt, wobei zwischen dem positiven Zwischenkreiszweig (1a) und dem negativen Zwischenkreiszweig (1b) eine Zwischenkreisgleichspannung (9) ansteht,
- einen Parallelschwingkreis aufweisend einen Kondensator (2) und eine dem Kondensator (2) parallel geschaltete Induktionsheizspule (3), wobei mittels der Induktionsheizspule (3) ein magnetisches Wechselfeld zum Beheizen eines Kochgeschirrs (200) erzeugbar ist,
- ein Halbleiterschaltmittel (4),
- wobei der Parallelschwingkreis (2, 3) und das Halbleiterschaltmittel (4) in Reihe zwischen den positiven Zwischenkreiszweig (1a) und den negativen Zwischenkreiszweig (1b) eingeschleift sind, und
- eine Steuereinheit (8), die dazu ausgebildet ist, das Halbleiterschaltmittel (4) derart anzusteuern, dass ein Verfahren nach einem der vorhergehenden Ansprüche ausgeführt wird.

9. Induktionsheizeinrichtung (100) nach Anspruch 8, aufweisend:
- eine Gleichspannungsversorgung (10) zur, insbesondere stabilisierten, Erzeugung der Zwischenkreisgleichspannung (9).
